# EUROPEAN PATENT APPLICATION

(11) **EP 4 697 471 A1**
(43) Date of publication of application: **18.02.2026**
(21) Application number: 25178975.6
(22) Date of filing: 27.05.2025
(51) Int. Cl.: H01M 50/247, A24F 40/40, A24F 40/51, A24F 40/60

(54) **POWER SUPPLY DEVICE AND ELECTRONIC ATOMIZER**

(30) Priority: 14.08.2024 CN 202411113283
(71) Applicant: Shenzhen Geekvape Technology Co., Ltd., Shenzhen, Guangdong 518100 (CN)
(72) Inventor: LI, Xiong, Shenzhen, 518100 (CN)
(74) Representative: MERH-IP Matias Erny Reichl Hoffmann Patentanwälte PartG mbB

(57) **Abstract**

The present application is applicable to technical field of electronic atomization, and provides a power supply device (10) and an electronic atomizer (100). The electronic atomizer (100) includes: an atomization device (20) and a power supply device (10). The power supply device (10) includes: a housing assembly (11); a battery (12), arranged in the housing assembly (11); a circuit board assembly (13), arranged in the housing assembly (11) and in electrical connection with the battery (12); a touch screen (141), mounted on the housing assembly (11) and in electrical connection with the circuit board assembly (13); and an unlock switch (15), in electrical connection with the circuit board assembly (13) and configured to lock or unlock the touch screen (141). The power supply device (10) includes the unlock switch (15) in electrical connection with the circuit board assembly (13), and the unlock switch (15) is configured to lock or unlock the touch screen (141). By operating the unlock switch (151), the touch screen (141) can be locked, so that the touch screen (141) cannot be touched. In this way, the problem of the touch screen (141) being accidentally touched can be improved, so as to improve the user experience of the electronic atomizer (100) including the power supply device (10).

## Description

### TECHNICAL FIELD

The present application relates to the technical field of electronic atomization, more particularly to a power supply device and an electronic atomizer.

### BACKGROUND

An electronic atomizer refers to a device used to heat an E-liquid, also called an electronic cigarette liquid, so that the E-liquid is atomized to form an aerosol. The aerosol formed by the atomization of the E-liquid can be used for inhalation by the user.

An electronic atomizer generally includes an atomization device and a power supply device, the power supply device is used to power the atomization device, and the atomization device is used to heat the E-liquid to form the aerosol. The power supply device includes a battery and a control assembly. By operating the control assembly, the circuit between the battery and the atomization device can be closed, so that the atomization device is started to perform the atomization, thereby heating the E-liquid to form an aerosol. However, the control assembly is inevitably at risk of being accidentally touched.

### SUMMARY

It is one of objectives of embodiments of the present application to provide a power supply device and an electronic atomizer, which can improve the problem that the control assembly of the electronic atomizer is easily touched by mistake.

In order to solve the above technical problems, the technical solutions adopted by embodiments of the present application are as follows:
In a first aspect, embodiments of the present application provides a power supply device, including:
a housing assembly;
a battery, arranged in the housing assembly;
a circuit board assembly, arranged in the housing assembly and in electrical connection with the battery;
a touch screen, mounted on the housing assembly and in electrical connection with the circuit board assembly; and
an unlock switch, in electrical connection with the circuit board assembly and configured to lock or unlock the touch screen.

In some embodiments, the power supply device further includes a start switch, the start switch is in electrical connection with the circuit board assembly, and the unlock switch is further configured to lock or unlock the start switch.

In some embodiments, the unlock switch includes:
a switch plate, in electrical connection with the circuit board assembly; and
an unlock portion, connected with the switch plate and configured to slide on the switch plate to lock or unlock the touch screen.

In some embodiments, the power supply device further includes a toggle member and a limit member, the limit member is connected with the housing assembly, and the toggle member is slidably arranged on the housing assembly and connected with the unlock portion to drive the unlock portion to move; and
the toggle member is provided with a plurality of first concave portions spaced apart in a sliding direction of the unlock portion, the limit member is provided with a first convex portion, the first convex portion is configured to alternately engage with the plurality of first concave portions in a concave-convex fitting manner; and/or the limit member is provided with a plurality of second concave portions spaced apart in the sliding direction of the unlock portion, the toggle member is provided with a second convex portion, the second convex portion is configured to alternately engage with the plurality of second concave portions in a concave-convex fitting manner.

In some embodiments, the power supply device further includes a gas pressure sensing element, which is arranged in the housing assembly and in electrical connection with the circuit board assembly and is configured to sense gas pressure changes. The housing assembly is provided with a first gas vent in communication with the gas pressure sensing element.

In some embodiments, the circuit board assembly includes a circuit board arranged in the housing assembly. The battery, the touch screen, the unlock switch, and the gas pressure sensing element are all in electrical connection with the circuit board. The circuit board is provided with a first through hole, the gas pressure sensing element is arranged on one side of the circuit board and covers the first through hole.

The power supply device further includes a first seal. The first seal is sealed at a side of the circuit board away from the gas pressure sensing element, and an orthographic projection of the first seal on the circuit board covers the first through hole. A second through hole is formed through the first seal, and the second through hole communicates between the first through hole and the first gas vent.

In some embodiments, a sealing groove is provided in the housing assembly, and the sealing groove includes a mounting groove section and a liquid accumulation groove section. The mounting groove section is arranged at the side of the circuit board away from the gas pressure sensing element, and at least a portion of the first seal is installed in the mounting groove section. The liquid accumulation groove section is in communication with an end of the mounting groove section away from the circuit board, and the first gas vent is in communication with the liquid accumulation groove section.

In some embodiments, the housing assembly is provided with a protective portion on a side of the battery, and the first gas vent is defined at the protective portion.

The power supply device further includes a second seal. The second seal is arranged at a side of the protective portion away from the battery. A gas venting passage, which is in communication with the first gas vent, is formed between the second seal and the protective portion. A plurality of second gas vents are formed through the second seal and spaced apart from each other. The plurality of second gas vents communicate with each other via the gas venting passage, and the plurality of second gas vents are configured to alternately mate with and communicate with an atomization device.

In some embodiments, the housing assembly is further provided with a mounting portion, the mounting portion is enclosed around outer peripheries of the protective portion and the second seal, and is enclosed with the second seal to form a mounting slot, which is configured to mount the atomization device. The plurality of second gas vents are exposed in the mounting slot. On a projection surface perpendicular to a distribution direction of the second seal and the protective portion, an inner contour of the mounting slot is a centrally symmetrical and non-circular, and the plurality of the second gas vents are symmetrically arranged relative to a center point of the mounting slot.

In a second aspect, embodiments of the present application provide an electronic atomizer, including:
the power supply device; and
an atomization device, configured to connect the housing assembly of the power supply device and to establish an electrical connection with the circuit board assembly.

Beneficial effects of the power supply device and the electronic atomizer provided by the embodiment of the present application are summarized as follows:
In the power supply device provided in embodiments of the present application, the power supply device includes the unlock switch in electrical connection with the circuit board assembly, and the unlock switch is configured to lock or unlock the touch screen. By operating the unlock switch, the touch screen can be locked, so that the touch screen cannot be touched. In this way, the problem of the touch screen being accidentally touched can be improved, so as to improve the user experience of the electronic atomizer including the power supply device.

The electronic atomizer provided in embodiments of the present application can improve the problem of accidental touch of the touch screen by adopting the power supply device involved in the above embodiments, so as to improve the user experience of the electronic atomizer.

The above description is only an overview of the technical solutions of the present application. In order to more clearly understand the technical means of the present application, and enable it to be implemented according to the content of the specification, and in order to make the above and other purposes, features, and advantages of the present application more obvious and easy to understand, the specific implementation methods of the present application are specifically cited below.

### BRIEF DESCRIPTION OF THE DRAWINGS

In order to more clearly illustrate the technical solutions in the embodiments of the present application, the drawings that need to be used in the description of the embodiments or the prior art will be briefly described hereinbelow. Obviously, the accompanying drawings in the following description are only some embodiments of the present application. For those skilled in the art, other drawings can be obtained based on these drawings without creative work.
FIG. 1 is a three-dimensional structural diagram of an electronic atomizer provided in some embodiments of the present application;
FIG. 2 is an exploded diagram of FIG. 1;
FIG. 3 is a structural diagram showing arrangement of a circuit board assembly 13, an unlock switch 15, a start switch 142, and a gas pressure sensing element 18 of the power supply device 10 provided in some embodiments of the present application;
FIG. 4 is a three-dimensional structural diagram of a power supply device provided in some embodiments of the present application;
FIG. 5 is a cross-sectional view taken from line A-A of FIG. 4;
FIG. 6 is an enlarged view of Part B in FIG. 5;
FIG. 7 is a partial schematic diagram of the power supply device provided in FIG. 4;
FIG. 8 is a partial structural diagram of the power supply device provided in FIG. 7;
FIG. 9 is a cross-sectional view taken from line C-C of FIG. 4;
FIG. 10 is an enlarged view of Part D in FIG. 9;
FIG. 11 is an enlarged view of Part E in FIG. 2;
FIG. 12 is a three-dimensional structural diagram of a housing assembly, a second seal, a toggle member, and a limit member of the power supply device provided in FIG. 4;
FIG. 13 is a cross-sectional view taken from line F-F of FIG. 4; and
FIG. 14 is a schematic diagram of the power supply device provided in FIG. 4.

Reference numerals in the drawings are explained as follows:
100 - electronic atomizer; 10 - power supply device; 101 - gas venting passage; 102 - mounting slot; 11 - housing assembly; 1101 - first gas vent; 1102 - sealing groove; 11021 - mounting groove section; 11022 - liquid accumulation groove section; 1103 - slide groove; 1104 - mounting hole; 1105 - window; 111 - housing; 1111 - mounting portion; 112 - mounting frame; 1121 - protective portion; 1122 - frame; 113 - light guide frame; 114 - transparent cover; 12 - battery; 13 - circuit board assembly; 1301 - first through hole; 131 - circuit board; 132 - conductive member; 14 - control assembly; 141 - touch screen; 142 - start switch; 15 - unlock switch; 151 - switch plate; 152 - unlock portion; 16 - toggle member; 1601 - first concave portion; 161 - slide portion; 162 - toggle portion 17 - limit member; 171 - limit portion; 1711 - first convex portion; 172 - hook; 18 - gas pressure sensing element; 19 - seal assembly; 1901 - second through hole; 1902 - second gas vent; 191 - first seal; 192 - second seal; 193 - third seal; 20 - atomization device; 201 - suction passage; a - center point; X - first direction; Z - second direction; and Y - third direction.

### DETAILED DESCRIPTION OF THE EMBODIMENTS

Embodiments of the present application are described in detail hereinbelow, and the examples of the embodiments are illustrated in the drawings, in which, the same or similar reference numerals are used to refer to the same or similar elements or elements having the same or similar functions. The embodiments described hereinbelow with reference to the accompanying drawings are intended to explain the application rather than to limit the present application.

It should be understood that terms "length", "width", "upper", "lower", "front", "rear", "left", "right", "vertical", "horizontal", "top", "bottom", "inside", "outside" and the like indicating orientation or positional relationship are based on the orientation or the positional relationship shown in the drawings, and are merely for facilitating and simplifying the description of the present application, rather than indicating or implying that a device or component must have a particular orientation, or be configured or operated in a particular orientation, and thus should not be construed as limiting the application.

Moreover, the terms "first" and "second" are adopted for descriptive purposes only and are not to be construed as indicating or implying a relative importance or implicitly indicating the number of technical features indicated. Thus, features prefixed by "first" and "second" will explicitly or implicitly represent that one or more of the referred technical features are included.

In the description of this application, "a plurality of' or "multiple" means more than two, unless otherwise clearly and specifically defined, and "more than two" includes two. Accordingly, ""a plurality of/multiple groups" means more than two groups, including two groups.

In the present application, unless otherwise specifically stipulated and defined, terms like "install", "connect", "couple", "fix" should be construed broadly, for example, they may indicate a fixed connection, a detachable connection, or an integral as a whole; may be a mechanical connection, or an electrical connection; may be in direct connection, or indirect connection via an intermediate, and may also reflect internal communication of two elements or interactions between two elements. For those skilled in the art, the specific meanings of the above terms in the present application can be understood according to specific conditions.

In the description of this application, the term "and/or" is only a description of the association relationship of associated objects, indicating that three relationships may exist, for example, A and/or B, which may mean the following conditions: A exists alone, A and B exist simultaneously, and B exists alone. In addition, the character "/" generally indicates that the contextual objects have an "or" relationship.

Although the present application has been described with reference to preferred embodiments, various modifications may be made thereto and parts thereof may be replaced with equivalents without departing from the scope of the present application. In particular, the various technical features mentioned in the various embodiments may be combined in any manner as long as there are no structural conflicts. The present application is not limited to the specific embodiments disclosed herein, but includes all technical solutions falling within the scope of the claims.

An electronic atomizer refers to a device used to heat an E-liquid, so that the E-liquid is atomized to form an aerosol. The aerosol formed by the atomization of the E-liquid can be used for inhalation by the user.

An electronic atomizer generally includes an atomization device and a power supply device, the power supply device is used to power the atomization device, and the atomization device is used to heat the E-liquid to form the aerosol. The power supply device includes a battery and a control assembly. By operating the control assembly, the circuit between the battery and the atomization device can be closed, so that the atomization device is started to perform the atomization, thereby heating the E-liquid to form an aerosol. However, the control assembly is inevitably at risk of being accidentally touched, which affects the user's experience.

In some cases, the control assembly may include a touch screen. By operating the touch screen, the atomization device can be started or shut down, and the multiple atomization modes of the electronic atomizer can be switched. However, the touch screen is operated by touch, which makes the touch screen very easy be accidentally touched, affecting the user's experience.

For example, when the user holds the electronic atomizer and the atomization device is started to perform the atomization to atomize the E-liquid to form the aerosol, the user is likely to touch the touch screen accidentally, so that the atomization process of the atomization device is shut down, the work mode of the atomization device is changed, etc., affecting the normal use of the user.

In view of this, embodiments of the present application provide a power supply device and an electronic atomizer, which can improve the problem that the control assembly of the electronic atomizer is easily touched by mistake.

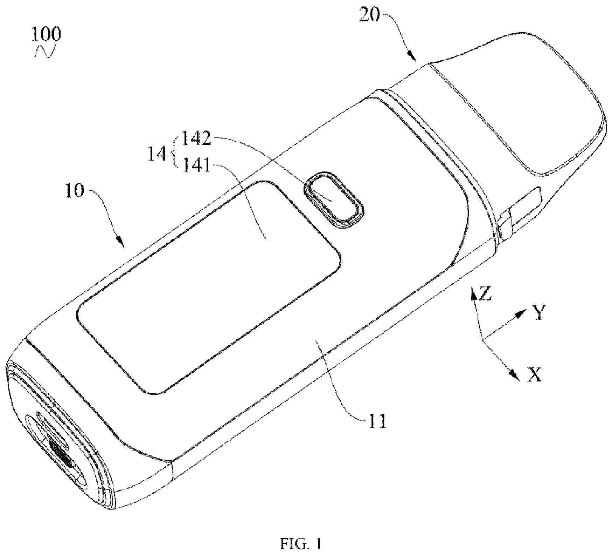

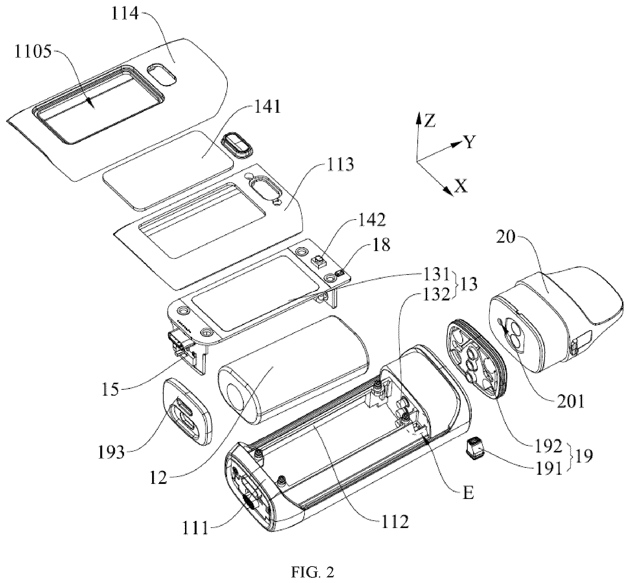

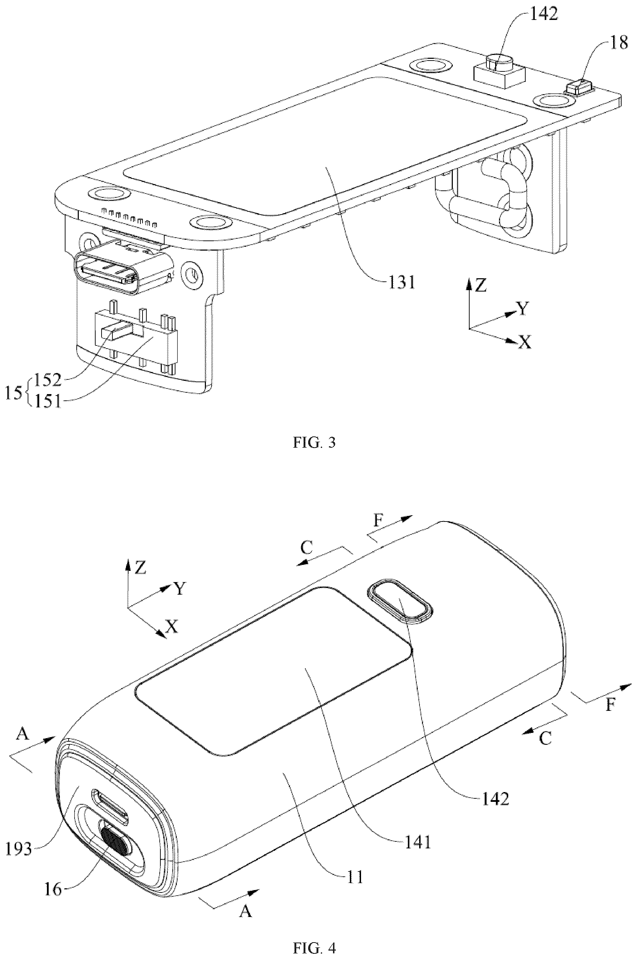

Referring to FIGS. 1-3, in which, FIG. 1 is a three-dimensional structural diagram of an electronic atomizer 100 provided in some embodiments of the present application, FIG. 2 is an exploded diagram of FIG. 1, and FIG. 3 is a structural diagram showing arrangement of a circuit board assembly 13, an unlock switch 15, a start switch 142, and a gas pressure sensing element 18 of the power supply device 10 provided in some embodiments of the present application. The power supply device 10 provided in embodiments of the present application includes: a housing assembly 11, a battery 12, a circuit board assembly 13, a control assembly 14, and an unlock switch 15. The battery 12 is arranged in the housing assembly 11. The circuit board assembly 13 is arranged in the housing assembly 11 and is in electrical connection with the battery 12. The control assembly 14 includes a touch screen 141. The touch screen 141 is mounted on the housing assembly 11 and is in electrical connection with the circuit board assembly 13. The unlock switch 15 is in electrical connection with the circuit board assembly 13 and is configured to lock or unlock the touch screen 141.

The housing assembly 11 is configured to form the housing of the power supply device 10. The battery 12 and the circuit board assembly 13 are both arranged in the housing assembly 11, so that the housing assembly 11 can protect the battery 12 and the circuit board assembly 13.

The circuit board assembly 13 is an assembly structure composed of one or more circuit boards 131, and is mainly used to control the operation of the atomization device 20. For example, the circuit board assembly 13 may control the atomization device 20 to start or shut down, and may also control the change of the atomization mode of the atomization device 20, etc. The circuit board 131 of the circuit board assembly 13 may be a flexible circuit board 131, a hard circuit board 131, etc.

The touch screen 141 is also called a "touch screen" or "touch panel", which is an inductive liquid crystal display device that can receive input signals from a contact. The touch screen 141 may be, but is not limited to, an infrared touch screen, a capacitive touch screen, etc.

The unlock switch 15 is a switch structure that can be used for user operation. The user can lock the touch screen 141 or unlock the touch screen 141 by operating the unlock switch 15. Specifically, when the user operates the unlock switch 15, the circuit board assembly 13 can receive a signal from the unlock switch 15, thereby controlling the touch screen 141 to lock or unlock. The unlock switch 15 may be a switch structure, such as a push-button switch, a touch-sensitive switch, or a slide switch.

When the touch screen 141 is unlocked, the user can operate the touch screen 141, the circuit board assembly 13 receives the signal from the touch screen 141, and controls the atomization device 20 to start, shut down, change the atomization mode, etc. For example, when the user operates the touch screen 141, the circuit board assembly 13 can receive the signal from the touch screen 141, and control the battery 12 to supply power to the atomization device 20, so that the atomization device 20 starts and performs atomization. Among them, the atomization mode of the atomization device 20 can include different atomization amounts, different atomization times, and other modes.

When the touch screen 141 is locked, the user is unable to operate the touch screen 141.

The power supply device 10 provided in embodiments of the present application includes the touch screen 141 in electrical connection with the circuit board assembly 13, so that the user can control the atomization device 20 by operating the touch screen 141. In this way, the operation of the electronic atomizer 100 is very intelligent and convenient.

In the power supply device 10 provided in embodiments of the present application, the power supply device 10 includes the unlock switch 15 in electrical connection with the circuit board assembly 13, and the unlock switch 15 is configured to lock or unlock the touch screen 141. By operating the unlock switch 15, the touch screen 141 can be locked, so that the touch screen 141 cannot be touched. In this way, the problem of the touch screen 141 being accidentally touched can be improved, so as to improve the user experience of the electronic atomizer 100 including the power supply device 10.

For example, when the atomization device 20 is started to perform the atomization operation, the user can lock the touch screen 141 by operating the unlock switch 15 to solve the problem that the user accidentally touches the touch screen 141, causing the atomization device 20 to be turned off and the work mode of the atomization device 20 to be changed.

In some embodiments, referring to FIGS. 1-3 in combination with other figures, the power supply device 10 further includes a start switch 142, which is in electrical connection with the circuit board assembly 13, and the unlock switch 15 is further configured to lock or unlock the start switch 142.

It can be understood that the control assembly 14 can further include a start switch 142.

The start switch 142 is a switch structure that can be used to start the atomization device 20 or turn off the atomization device 20. The start switch 142 can be a switch structure, such as a push-button switch, a touch-sensitive switch, or a slide switch. As an example, as shown in FIGS. 1-2, the start switch 142 is a push-button switch.

When the user operates the unlock switch 15, the start switch 142 can be locked or unlocked. Specifically, when the user operates the unlock switch 15, the circuit board assembly 13 can receive the signal of the unlock switch 15, thereby controlling the start switch 142 to be locked or unlocked. When the start switch 142 is unlocked, the user can operate the start switch 142, such that the circuit board assembly 13 receives the signal of the start switch 142, and controls the atomization device 20 to start or shut down. When the start switch 142 is locked, the user cannot operate the start switch 142.

By adopting the above technical solution, the user can operate the touch screen 141 to control the atomization device 20; or operate the start switch 142 to control the atomization device 20. Such a configuration enables the electronic atomizer 100 to have more operation modes and higher portability. The user can operate the touch screen 141 or the start switch 142 according to preference, which is conducive to improving the comfort of use of the electronic atomizer 100. In addition, by operating the unlock switch 15, the start switch 142 can be locked, so that the start switch 142 cannot be operated. In this way, the problem of the start switch 142 being accidentally touched can be improved, so as to improve the user experience of the electronic atomizer 100 including the power supply device 10.

It should be supplemented here that the unlock switch 15 may include multiple gears, including at least two of the following gears: a gear in which both the start switch 142 and the touch screen 141 are locked, a gear in which both the start switch 142 and the touch screen 141 are unlocked, a gear in which the start switch 142 is locked and the touch screen 141 is unlocked, and a gear in which the start switch 142 is unlocked and the touch screen 141 is locked. By operating the unlock switch 15, the gear position of the unlock switch 15 can be adjusted.

In some embodiments, referring to FIG. 2 and FIG. 3 in combination with other figures, the unlock switch 15 includes a switch plate 151 and an unlock portion 152. The switch plate 151 is in electrical connection with the circuit board assembly 13. The unlock portion 152 is connected with the switch plate 151 and is configured to slide on the switch plate 151 to lock or unlock the touch screen 141.

The switch plate 151 is a board of the unlock switch 15 for electrically connecting to the circuit board assembly 13, and the unlock portion 152 refers to a switch for sliding on the switch plate 151 to achieve locking or unlocking.

The unlock portion 152 can slide on the switch plate 151, so that the user can push the unlock portion 152 to slide, so as to adjust the gear position of the unlock switch 15, thereby locking or unlocking the touch screen 141. In this way, it is convenient for the unlock switch 15 to adjust the gear position.

It should also be noted that the user can push the unlock portion 152 to slide, so as to adjust the gear position of the unlock switch 15, thereby locking or unlocking the start switch 142.

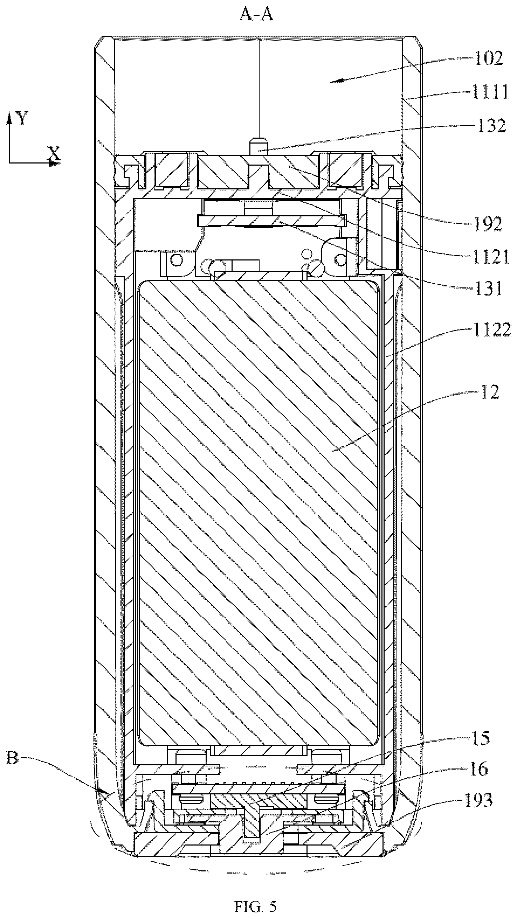

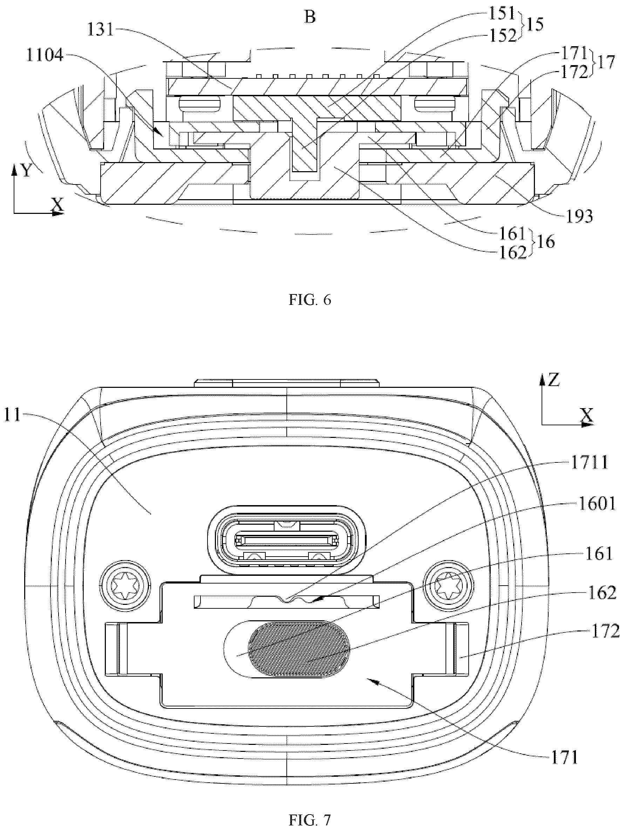

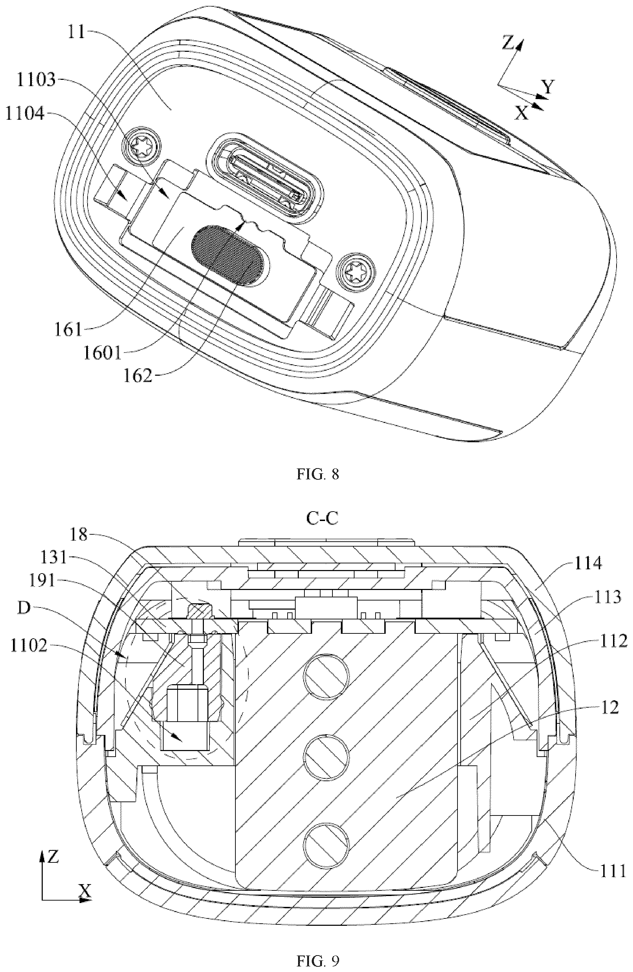

In some embodiments, referring to FIGS. 2-8 in combination with other figures, in which, FIG. 4 is a three-dimensional structural diagram of the power supply device 10 provided in some embodiments of the present application, FIG. 5 is a cross-sectional view taken from line A-A of FIG. 4, FIG. 6 is an enlarged view of Part B in FIG. 5, FIG. 7 is a partial schematic diagram of a power supply device 10 provided in FIG. 4, and FIG. 8 is a partial structural diagram of the power supply device 10 provided in FIG. 7, the power supply device 10 further includes a toggle member 16 and a limit member 17, and the limit member 17 is connected with the housing assembly 11. The toggle member 16 is slidably arranged on the housing assembly 11 and connected with the unlock portion 152 to drive the unlock portion 152 to move.

The toggle member 16 is a component for the user to toggle so that the unlock portion 152 slides under the drive of the toggle member 16, thereby realizing the gear adjustment of the unlock switch 15. The toggle member 16 is connected with the unlock portion 152, so that the user can toggle the toggle member 16 to drive the unlock portion 152 to slide, thereby realizing the gear adjustment of the unlock switch 15.

The limit member 17 refers to a component used to limit the position of the toggle member 16.

In some possible designs, referring to FIGS. 6-8 in combination with other figures, the toggle member 16 is provided with a plurality of first concave portions 1601, and the first concave portions 1601 are spaced apart in a sliding direction of the unlock portion 152. The limit member 17 is provided with a first convex portion 1711, and the first convex portion 1711 is configured to alternately engage with the plurality of first concave portions 1601 in a concave-convex fitting manner.

Through the concave-convex engagement of the first convex portion 1711 and the first concave portions 1601, at least a portion of the first convex portion 1711 is limited in the first concave portions 1601 in the sliding direction of the unlock portion 152, thereby limiting the sliding of the toggle member 16 in the sliding direction of the unlock portion 152 to a certain extent. In this way, the problem of the misadjustment of the gear position of the unlock switch 15, due that the toggle member 16 is easy to shake and be accidentally touched, can be solved.

When the user toggles the toggle member 16, the toggle member 16 slides in the sliding direction of the unlock portion 152, so that the plurality of first concave portions 1601 can alternately slide to the first convex portion 1711, thereby alternately engaging with the first convex portion 1711 in a concave-convex fitting manner. In this way, a certain sense of jamming will be generated when the toggle member 16 is toggled, and this sense of jamming will be generated when each first concave portion 1601 engages with the first convex portion 1711 in a concave-convex fitting manner. In this way, the number of first concave portions 1601 can be set to be the same as the number of gears of the unlock switch 15, and each first concave portion 1601 corresponds to each gear, so as to facilitate the gear memory and adjustment of the unlock switch 15.

In some possible designs, the limit member 17 is provided with a plurality of second concave portions, which are spaced apart in the sliding direction of the unlock portion 152. The toggle member 16 is provided with a second convex portion, which is configured to alternately engage with the plurality of second concave portions in a concave-convex fitting manner.

Through the concave-convex engagement of the second convex portion and the second concave portions, at least a part of the second convex portion is limited in the second concave portions in the sliding direction of the unlock portion 152, thereby limiting the sliding of the toggle member 16 in the sliding direction of the unlock portion 152 to a certain extent. In this way, the problem of the misadjustment of the gear position of the unlock switch 15, due that the toggle member 16 is easy to shake and be accidentally touched, can be solved.

When the user toggles the toggle member 16, the toggle member 16 slides in the sliding direction of the unlock portion 152, so that the second convex portion can slide to the second concave portions alternately, thereby alternately engaging with the second concave portions in a concave-convex fitting manner. In this way, a certain sense of jamming will be generated when the toggle member 16 is toggled, and this sense of jamming will be generated when the second convex portion engages with each second concave portion in a concave-convex fitting manner. In this way, the number of second concave portions can be set to be the same as the number of gears of the unlock switch 15, and each second concave portion corresponds to each gear, so as to facilitate the gear memory and adjustment of the unlock switch 15.

It should be supplemented here that when the toggle member 16 is provided with a second convex portion and a plurality of first concave portions 1601 spaced apart in the sliding direction of the unlock portion 152, the second convex portion is arranged between two adjacent first concave portions 1601 in the sliding direction of the unlock portion 152, so that the second convex portion and the two adjacent first concave portions 1601 present a continuous concave-convex arrangement. When the limit member 17 is provided with a first convex portion 1711 and a plurality of second concave portions spaced apart in the sliding direction of the unlock portion 152, the first convex portion 1711 is arranged between two adjacent second concave portions in the sliding direction of the unlock portion 152, so that the first convex portion 1711 and the two adjacent second concave portions present a continuous concave-convex arrangement.

In some possible designs, the toggle member 16 may be provided with a plurality of second convex portions spaced apart in the sliding direction of the unlock portion 152, and the limit member 17 may be provided with a plurality of first convex portions spaced apart in the sliding direction of the unlock portion 152. Along the sliding direction of the unlock portion 152, the first concave portions 1601 and the second convex portions are alternately arranged in a concave-convex manner, and the second concave portions and the first convex portion 1711 are alternately arranged in a concave-convex manner.

In some embodiments, referring to FIG. 3 to FIG. 8 in combination with other figures, the toggle member 16 is arranged across the housing assembly 11 so that the toggle member 16 can be connected with the unlock portion 152, and at least a portion of the toggle member 16 can protrudes out of the housing assembly 11, so that the user can toggle the toggle member 16 to operate the unlock switch 15 to adjust the gear position of the unlock switch 15.

For ease of description, the sliding direction of the unlock portion 152 is defined as a first direction X.

The first convex portion 1711 and the first concave portion 1601 can be matched in a concave-convex manner along a second direction Z, and the second convex portion and the second concave portion can be matched in a concave-convex manner along the second direction Z. The second direction Z is perpendicular to the first direction X.

The toggle member 16 is arranged in the housing assembly 11 along the third direction Y, so that the toggle member 16 can be connected with the unlock portion 152, and at least a portion of the toggle member 16 can protrude out of the housing assembly 11 along the third direction Y for the user to toggle. The third direction Y is perpendicular to the first direction X, and the third direction Y is perpendicular to the second direction Z.

For ease of description, the first direction X, the second direction Z, and the third direction Y may all be double-arrow directions.

In some cases, the first direction X may be the width direction of the electronic atomizer 100, the second direction Z may be the thickness direction of the electronic atomizer 100, and the third direction Y may be the length direction of the electronic atomizer 100.

In some embodiments, referring to FIG. 5 and FIG. 6 in combination with other figures, the unlock portion 152 is inserted into the toggle member 16 along the third direction Y, so that the unlock portion 152 can be limited in the toggle member 16 at least along the first direction X. In this way, when the toggle member 16 is toggled along the first direction X, the unlock portion 152 can slide along the first direction X driven by the toggle member 16 to achieve gear adjustment.

In some embodiments, referring to FIGS. 1-6 in combination with other figures, at least part of the toggle member 16 is exposed to one end of the housing assembly 11 along the third direction Y, and the other end of the housing assembly 11 is used to install the atomization device 20.

In some embodiments, referring to FIGS. 6-8 in combination with other figures, a slide groove 1103 is provided at one end of the housing assembly 11 along the third direction Y, and the slide groove 1103 extends along the first direction X. At least a part of the toggle member 16 is limited in the slide groove 1103 and can slide along the slide groove 1103 in the first direction X. In this way, the slide groove 1103 can limit the toggle member 16, so as to facilitate the toggle member 16 to be toggled, so as to facilitate the gear adjustment of the unlock switch 15.

In some embodiments, referring to FIGS. 6-8 in combination with other figures, the limit member 17 includes a limit portion 171 and a plurality of hooks 172, and the plurality of hooks 172 are spaced apart and distributed on the limit portion 171.

When the limit member 17 is provided with the above-mentioned first convex portion 1711, the first convex portion 1711 can be arranged at the limit portion 171. When the limit member 17 is provided with the above-mentioned second concave portion, the second concave portion can be arranged at the limit portion 171.

A plurality of mounting holes 1104 are spaced apart from each other and are arranged at one end of the housing assembly 11 along the third direction Y, and the limit portion 171 is limited at one end of the housing assembly 11 along the third direction Y. The plurality of hooks 172 pass through the plurality of mounting holes 1104, respectively, and are elastically connected with the housing assembly 11. This arrangement facilitates the installation of the limit member 17 on the housing assembly 11.

In some embodiments, referring to FIGS. 6-8 in combination with other figures, the toggle member 16 includes a slide portion 161 and a toggle portion 162 connected with the slide portion 161, and the toggle portion 162 is connected with the unlock portion 152.

When the toggle member 16 is provided with the above-mentioned second convex portion, the second convex portion can be arranged at the slide portion 161. When the toggle member 16 is provided with the above-mentioned first concave portion 1601, the first concave portion 1601 can be arranged at the slide portion 161.

In the third direction Y, the slide portion 161 is limited between the limit portion 171 and the housing assembly 11, and the toggle portion 162 is arranged across the limit portion 171 so that the toggle portion 162 can be toggled by the user.

In other embodiments, the limit member 17 and at least a part of the housing assembly 11 can be integrally connected.

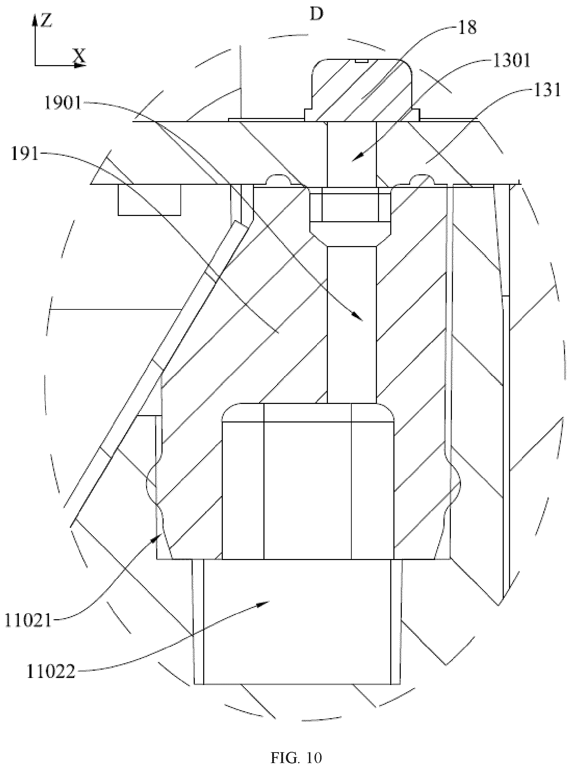

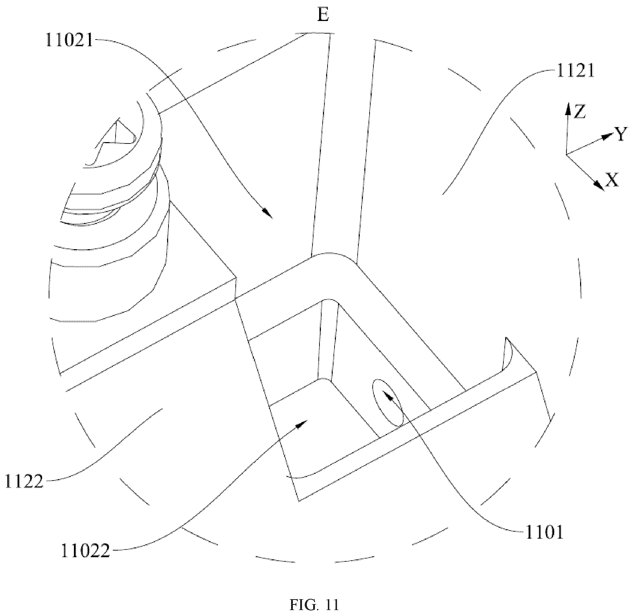

In some embodiments, referring to FIGS. 2-3 and FIGS. 9-11 in combination with other figure, FIG. 9 is a cross-sectional view of taken from line C-C of FIG. 4, FIG. 10 is an enlarged view of Part D in FIG. 9, and FIG. 11 is an enlarged view of Part E in FIG. 2, the power supply device 10 further includes a gas pressure sensing element 18, which is arranged in the housing assembly 11 and in electrical connection with the circuit board assembly 13 and is configured to sense gas pressure changes. The housing assembly 11 is provided with a first gas vent 1101, and the first gas vent 1101 is in communication with the gas pressure sensing element 18.

The gas pressure sensing element 18 refers to a component that can be used to sense changes in gas pressure.

The fact that the first gas vent 1101 is in communication with the gas pressure sensing element 18 does not mean that the first gas vent 1101 must communicate with the inside of the gas pressure sensing element 18. It can be understood that the first gas vent 1101 can be in communication with the surface of the gas pressure sensing element 18 or with the inside of the gas pressure sensing element 18. In this way, the gas at the first gas vent 1101 can flow to the gas pressure sensing element 18, and the gas at the gas pressure sensing element 18 can also flow to the first gas vent 1101. The gas pressure sensing element 18 may include the surface and surroundings of the gas pressure sensing element 18, and may further include the inside of the gas pressure sensing element 18.

The gas pressure sensing element 18 is in electrical connection with the circuit board assembly 13 and is used to sense gas pressure changes, so that when the gas pressure at the gas pressure sensing element 18 changes, the gas pressure sensing element 18 can sense the gas pressure change and transmit the signal of the gas pressure change to the circuit board assembly 13, so that the circuit board assembly 13 controls the power delivery from battery 12 to the atomization device 20, so that the atomization device 20 starts and performs atomization. Therefore, the gas pressure sensing element 18 can be used as a switch to start the atomization device 20.

In this way, when the unlock switch 15 locks the touch screen 141 and the start switch 142, the user can perform a suction operation on the atomization device 20 or the power supply device 10 to operate the gas pressure sensing element 18, so that the gas at the gas pressure sensing element 18 flows to the first gas vent 1101, which makes the gas pressure at the gas pressure sensing element 18 change, thereby controlling the start of the atomization device 20.

Based on the above structure, the electronic atomizer 100 provided in embodiments of the present application can operate at least one of the touch screen 141, the start switch 142, and the gas pressure sensing element 18 to control the electronic atomizer 100. This allows the electronic atomizer 100 to have more operating modes and higher convenience, and can be applied to various different usage scenarios.

In some embodiments, referring to FIG. 2 and other figures, the atomization device 20 may be provided with a suction passage 201. When the atomization device 20 is mounted on the housing assembly 11, the circuit board assembly 13 may establish an electrical connection with the atomization device 20, and the suction passage 201 may communicate with the first gas vent 1101. In this way, the user may inhale through the suction passage 201, so that the gas at the gas pressure sensing element 18 flows to the first gas vent 1101 and the suction passage 201 in sequence, thereby causing gas pressure changes.

In some embodiments, in the third direction Y, the first gas vent 1101 is arranged at an end of the housing assembly 11 away from the unlock switch 15.

In some embodiments, referring to FIG. 3 in combination with other figures. The gas pressure sensing element 18 is a silicon wheat sensor, which is small in size and convenient for arrangement in the housing assembly 11, thereby helping to reduce the volume of the power supply device 10, thereby helping to reduce the volume of the electronic atomizer 100.

In some embodiments, referring to FIG. 3 and other figures, the gas pressure sensing element 18 is arranged on the circuit board assembly 13 and is in electrical connection with the circuit board assembly 13.

In some embodiments, referring to FIGS. 9-11 in combination with other figures, the circuit board assembly 13 includes a circuit board 131, and the circuit board 131 is arranged in the housing assembly 11. The battery 12, the touch screen 141, the unlock switch 15, and the gas pressure sensing element 18 are all in electrical connection with the circuit board 131. The circuit board 131 is provided with a first through hole 1301, and the gas pressure sensing element 18 is arranged on one side of the circuit board 131 and covers the first through hole 1301. The power supply device 10 further includes a seal assembly 19, and the seal assembly 19 includes a first seal 191. The first seal 191 is sealed at a side of the circuit board 131 away from the gas pressure sensing element 18, and an orthographic projection of the first seal 191 on the circuit board 131 covers the first through hole 1301. A second through hole 1901 is formed through the first seal 191, and the second through hole 1901 communicates between the first through hole 1301 and the first gas vent 1101.

Specifically, in the thickness direction of the circuit board 131, the circuit board 131 is penetrated to form a first through hole 1301, and the gas pressure sensing element 18 is arranged on one side of the circuit board 131.

The second through hole 1901 communicates between the first through hole 1301 and the first gas vent 1101, which means that on a flow path of the gas between the first through hole 1301 and the first gas vent 1101, the second through hole 1901 is arranged between the first through hole 1301 and the first gas vent 1101, and the first through hole 1301 and the first gas vent 1101 can be communicated through the second through hole 1901. In this way, when the user draws on the power supply device 10 or the atomization device 20 to operate the gas pressure sensing element 18, the gas at the gas pressure sensing element 18 will flow to the first gas vent 1101 through the first through hole 1301 and the second through hole 1901 in sequence.

The first seal 191 refers to a component with a sealing effect, and the material of the first seal 191 may be but is not limited to silicone.

The first seal 191 is sealed at the side of the circuit board 131 away from the gas pressure sensing element 18, which means that in the thickness direction of the circuit board 131, the first seal 191 is arranged on the side of the circuit board 131 away from the gas pressure sensing element 18, and the circuit board 131 and the first seal 191 are in seal connection.

The orthographic projection of the first seal 191 on the circuit board 131 refers to the projection of the first seal 191 onto the circuit board 131 along the thickness direction of the circuit board 131.

The first seal 191 is sealed on the side of the circuit board 131 away from the gas pressure sensing element 18, and the orthographic projection of the first seal 191 on the circuit board 131 covers the first through hole 1301, so that the circuit board 131 is in seal connection with the first seal 191 at the periphery of the first through hole 1301. In this way, on the one hand, when the user draws the power supply device 10 or the atomization device 20 to operate the gas pressure sensing element 18, the gas at the gas pressure sensing element 18 will flow directly to the second through hole 1901 of the first seal 191 via the first through hole 1301, so as to flow to the first gas vent 1101, which can improve the problem of the gas at the gas pressure sensing element 18 diffusing from the periphery of the first through hole 1301, thereby improving the sensing sensitivity of the gas pressure sensing element 18 and facilitating the improvement of the comfort of use of the electronic atomizer 100.

On the other hand, when the E-liquid or other liquid enters the housing assembly 11 through the first gas vent 1101, the arrangement of the second through hole 1901 in the first seal 191 increases the length of the path and the difficulty of the E-liquid or other liquid entering the first through hole 1301, which can effectively improve the problem of the short circuit of the gas pressure sensing element 18 caused by the E-liquid or other liquid entering the gas pressure sensing element 18. In addition, the problem of the E-liquid or other liquid spreading to other positions of the circuit board 131 through the first seal 191 and the circuit board 131 can also be improved, thereby improving the problem of the circuit board 131 being damaged due to moisture.

In some embodiments, the thickness direction of the circuit board 131 is parallel to the second direction Z.

It should be added that the start switch 142 is arranged on the circuit board 131 and is in electrical connection with the circuit board 131.

In some embodiments, referring to FIG. 9-11 in combination with other figures, a sealing groove 1102 is provided in the housing assembly 11, and the sealing groove 1102 includes a mounting groove section 11021 and a liquid accumulation groove section 11022. The mounting groove section 11021 is arranged at a side of the circuit board 131 away from the gas pressure sensing element 18, and at least a portion of the first seal 191 is installed in the mounting groove section 11021. The liquid accumulation groove section 11022 is in communication with an end of the mounting groove section 11021 away from the circuit board 131, and the first gas vent 1101 is in communication with the liquid accumulation groove section 11022.

Specifically, as shown in FIGS. 10-11, in the thickness direction of the circuit board 131, the first through hole 1301, the mounting groove section 11021, and the liquid accumulation groove section 11022 are distributed in sequence, that is, in the thickness direction of the circuit board 131, the mounting groove section 11021 is arranged between the first through hole 1301 and the liquid accumulation groove section 11022.

Specifically, in the thickness direction of the circuit board 131, the first seal 191 is in sealed connection with one side of the circuit board 131 away from the gas pressure sensing element 18, and the first seal 191 is in sealed connection with a groove wall of the sealing groove 1102.

The sealing groove 1102 includes the mounting groove section 11021 and the liquid accumulation groove section 11022, which can increase the path length and difficulty of the E-liquid or other liquid entering the first through hole 1301, and the liquid accumulation groove section 11022 can be used for liquid accumulation. In this way, the problem of the short circuit of the gas pressure sensing element 18, caused by the E-liquid or other liquid entering the gas pressure sensing element 18, can be effectively improved.

In some embodiments, as shown in FIG. 11 and in combination with other figures. The first gas vent 1101 is defined at the groove wall of the liquid accumulation groove section 11022.

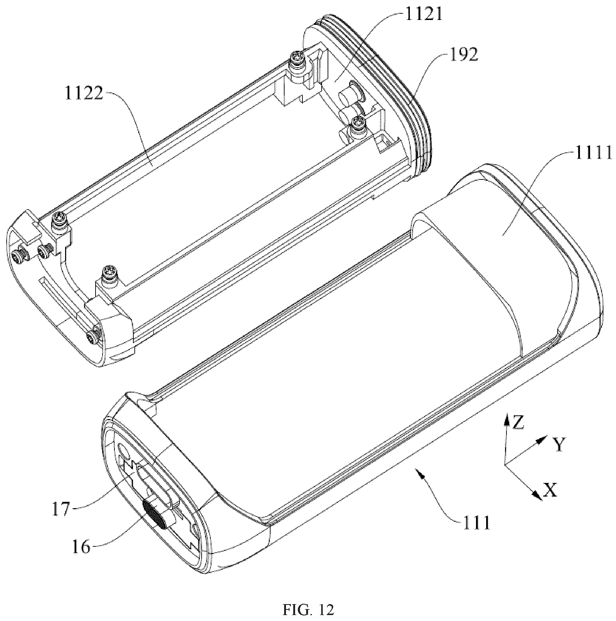

In some embodiments, referring to FIG. 5 and FIG. 12 in combination with other figures, in which, FIG. 12 is a three-dimensional structural diagram of a housing assembly 11, a second seal 192, a toggle member 16, and a limit member 17 of the power supply device 10 provided in FIG. 4. The housing assembly 11 is provided with a protective portion 1121 at a side of the battery 12, and the first gas vent 1101 is defined at the protective portion 1121.

Specifically, the protective portion 1121 is arranged on one side of the battery 12 along the third direction Y, and in the third direction Y, the battery 12 is arranged between the protective portion 1121 and the unlock switch 15.

The first gas vent 1101 is defined at the protective portion 1121, and the first gas vent 1101 may be arranged along the third direction Y through the protective portion 1121.

The housing assembly 11 is provided with a protective portion 1121 at one side of the battery 12, so that the protective portion 1121 can provide a certain protective effect on the battery 12.

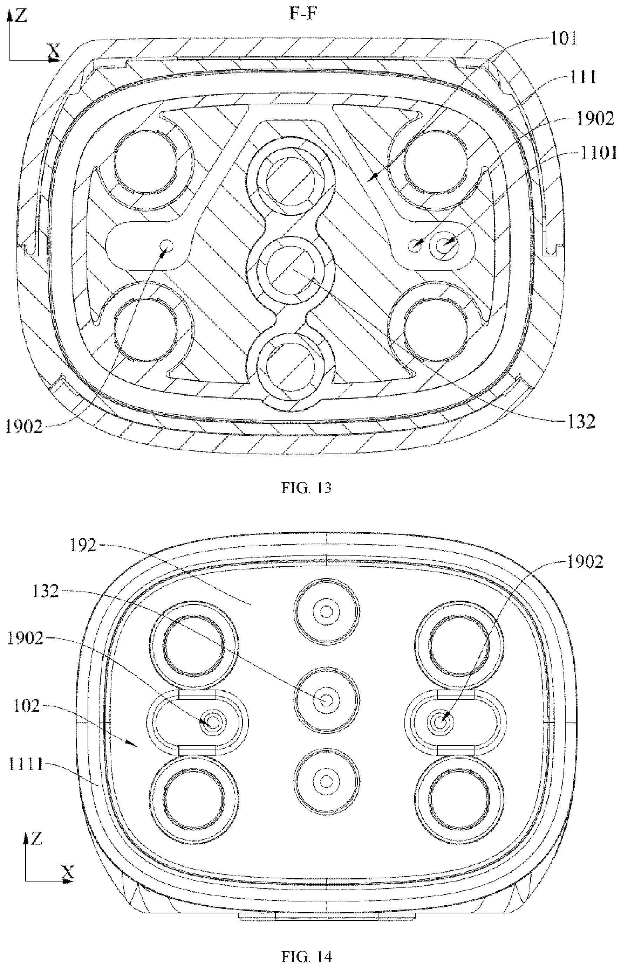

In some embodiments, referring to FIGS. 12-14 and in combination with other figures, in which, FIG. 13 is a cross-sectional view taken from line F-F of FIG. 4, and FIG. 14 is a schematic diagram of the power supply device 10 provided in FIG. 4. The power supply device 10 further includes a second seal 192, that is, the seal assembly 19 further includes a second seal 192. The second seal 192 is arranged at a side of the protective portion 1121 away from the battery 12, and a gas venting passage 101 is formed between the second seal 192 and the protective portion 1121, and the gas venting passage 101 is in communication with the first gas vent 1101. A plurality of second gas vents 1902 are formed through the second seal 192 and are spaced apart from each other, and the plurality of second gas vents 1902 communicate with each other via the gas venting passage 101, and the plurality of second gas vents 1902 are configured to alternately mate with and communicate with the atomization device 20.

The second seal 192 refers to a component having a sealing effect, and the material of the second seal 192 may be, but is not limited to, silicone.

The plurality of second gas vents 1902 are used to alternately mate with and communicate with the atomization device 20, which means that the plurality of second gas vents 1902 can alternately mate with and communicate with the suction passage 201 of the atomization device 20.

By adopting the above technical solution, when the user inhales through the suction passage 201 of the atomization device 20 to operate the gas pressure sensing element 18, the gas at the gas pressure sensing element 18 will flow to the gas venting passage 101 through the first through hole 1301, the second through hole 1901, and the first gas vents 1101 in sequence, and flow to the second gas vents 1902 through the gas venting passage 101, thereby flowing to the suction passage 201 of the atomization device 20.

By the arrangement of the plurality of second gas vents 1902 and configuring the plurality of second gas vents 1902 to alternately mate with and communicate with the atomization device 20, the atomization device 20 can be flexibly installed on the housing assembly 11 to mate with and communicate with at least one of the plurality of second gas vents 1902, thereby facilitating the installation between the atomization device 20 and the housing assembly 11.

As an example, as shown in FIGS. 13-14 in combination with other figures, the number of the second gas vents 1902 is two.

In addition, the gas venting passage 101 can be used for liquid accumulation. In this way, the problem of the short circuit of the gas pressure sensing element 18 caused by the E-liquid or other liquid entering the gas pressure sensing element 18 can be effectively improved.

In addition, the second seal 192 is in sealed connection with the side of the protective portion 1121 away from the battery 12, which helps to improve the problem that the E-liquid or other liquid flows into the housing assembly 11, causing the circuit board assembly 13 and other components to short-circuit.

Specifically, as shown in FIGS. 5 and 12, in the third direction Y, the second seal 192 is arranged on the side of the protective portion 1121 away from the battery 12.

In some embodiments, referring to FIGS. 12-14 in combination with other figures, the housing assembly 11 is also provided with a mounting portion 1111, and the mounting portion 1111 is enclosed around outer peripheries of the protective portion 1121 and the second seal 192, and is enclosed with the second seal 192 to form a mounting slot 102, and the mounting slot 102 is configured to mount the atomization device 20. The plurality of second gas vents 1902 are exposed in the mounting slot 102. On a projection surface perpendicular to a distribution direction of the second seal 192 and the protective portion 1121, an inner contour of the mounting slot 102 is centrally symmetric and non-circular, and the plurality of second gas vents 1902 are symmetrically arranged relative to a center point a of the mounting slot 102.

The mounting slot 102 is a groove formed by enclosing the mounting portion 1111 and the second seal 192 and configured for assembling the atomization device 20. The mounting slot 102 is arranged at the side of the protective portion 1121 away from the battery 12.

The plurality of second gas vents 1902 are arranged at the bottom of the mounting slot 102 so that the plurality of second gas vents 1902 can communicate with the mounting slot 102, so that the plurality of second gas vents 1902 are exposed in the mounting slot 102.

A part of the atomization device 20 can be installed in the mounting slot 102 to realize the installation of the atomization device 20 on the power supply device 10. When the atomization device 20 is installed in the mounting slot 102, the suction passage 201 of the atomization device 20 can mate with and communicate with the second gas vent 1902.

Referring to FIG. 14, and combine with other figures, the mounting slot 102 has a center point a. On the projection surface perpendicular to the distribution direction of the second seal 192 and the protective portion 1121, the inner contour of the mounting slot 102 is centrally symmetrically arranged relative to the center point a, so that the inner contour of the mounting slot 102 is a centrally symmetrical FIG. and is non-circular. For example, as shown in FIG. 14, on the projection surface perpendicular to the distribution direction of the second seal 192 and the protective portion 1121, the inner contour of the mounting slot 102 can be a square with rounded corners on the four corners, and it can also be an ellipse, a prism, or other shapes.

Furthermore, on the projection plane perpendicular to the distribution direction of the second seal 192 and the protective portion 1121, the plurality of second gas vents 1902 are centrally symmetrically arranged relative to the center point a of the mounting slot 102.

Correspondingly, on the projection plane perpendicular to the distribution direction of the second seal 192 and the protective portion 1121, at least a part of the atomization device 20 which is configured to be assembled in the mounting slot 102 is centrally symmetrically arranged relative to the center point a of the mounting slot 102, so that a part of the atomization device 20 can be assembled in the mounting slot 102.

As an example, as shown in FIGS. 5 and 14, the second seal 192 and the protective portion 1121 are distributed along the third direction Y, and in the third direction Y, the mounting slot 102 is arranged at the side of the protective portion 1121 away from the battery 12. On the projection plane perpendicular to the third direction Y, the size of the inner contour of the mounting slot 102 in the first direction X is different from the size of the inner contour of the mounting slot 102 in the second direction Z.

The number of the second gas vents 1902 is two, and the two second gas vents 1902 are spaced apart along the first direction X.

By adopting the above technical solution, the atomization device 20 can be flexibly assembled in the mounting slot 102, which is convenient for the installation and use of the electronic atomizer 100. In addition, the problem that the atomization device 20 is inserted in the mounting slot 102 in reverse, resulting in the inability to connect the suction passage 201 and the second gas vents 1902, can be improved, that is, even if the atomization device 20 is rotated 180° and then assembled in the mounting slot 102, there is still at least one of the second gas vents 1902 that is in communication with the suction passage 201. In this way, the installation and use of the electronic atomizer 100 is convenient.

In some embodiments, the circuit board assembly 13 may further include a conductive member 132, which is in electrical connection with the circuit board 131. When the atomization device 20 is assembled in the mounting slot 102, the atomization device 20 and the conductive member 132 mate with each other to establish electrical connection therebetween, so that the circuit board assembly 13 can control the battery 12 to supply power to the atomization device 20, so that the atomization device 20 can perform atomization.

The conductive member 132 can be but is not limited to a spring pin.

In some embodiments, referring to FIGS. 2, 5 and 12 in combination with other figures, the housing assembly 11 can include a housing 111 and a mounting frame 112, the mounting frame 112 is arranged in the housing 111, the battery 12 is arranged in the housing 111, and the mounting frame 112 is used to achieve position limiting.

Specifically, the mounting frame 112 may include a frame 1122 and the above-mentioned protective portion 1121. The frame 1122 is arranged in the housing 111, the battery 12 is arranged in the housing 111, and the frame 1122 is used to limit the position. In the third direction Y, the protective portion 1121 is arranged at a side of the frame 1122 away from the battery 12.

The sealing groove 1102 is arranged on the frame 1122.

In the third direction Y, the limit member 17, the toggle member 16, the mounting hole 1104 and the slide groove 1103 are all arranged at one end of the housing 111, and the mounting portion 1111 is arranged at the other end of the housing 111.

In the second direction Z, at least a part of the circuit board assembly 13 is arranged at the side of the battery 12 away from the mounting frame 112, and overlapped on the mounting frame 112.

In some embodiments, the power supply device 10 may further include a light guide frame 113 and a transparent cover 114. In the second direction Z, at least a portion of the light guide frame 113 is arranged on a side of the circuit board assembly 13 away from the battery 12, and at least a portion of the transparent cover 114 is arranged on a side of the light guide frame 113 away from the light guide frame 113.

In addition, the transparent cover 114 is provided with a window 1105, and the touch screen 141 is mounted at the window 1105.

In some embodiments, referring to FIG. 6 in combination with other figures, the seal assembly 19 may further include a third seal 193, and the material of the third seal 193 may be, but is not limited to, silicone.

In the third direction Y, the third seal 193 is arranged at one end of the housing assembly 11 where the limit member 17 is located, and the toggle member 16 protrudes out of the third seal 193.

The third seal 193 can achieve a certain sealing effect on the housing assembly 11 and provide a certain shock-absorbing effect on the movement of the toggle member 16.

The third seal 193 is arranged at one end of the housing 111 away from the mounting portion 1111 along the third direction Y.

Referring to FIG. 1 in combination with other figures, the electronic atomizer 100 provided in embodiments of the present application includes a power supply device 10 and an atomization device 20, and the atomization device 20 is configured to connect the housing assembly 11 of the power supply device 10 and to establish an electrical connection with the circuit board assembly 13. For specific details, reference may be made to the relevant descriptions of the power supply device 10 in the preceding embodiments, which are not repeated herein

The electronic atomizer 100 provided in embodiments of the present application, by adopting the power supply device 10 involved in the above embodiments, can improve the problem of the touch screen 141 being accidentally touched, so as to improve the user experience of the electronic atomizer 100.

The above description is only a preferred embodiment of the present application and is not intended to limit the present application. Any modifications, equivalent substitutions, and improvements made within the embodiments of the present application should be included in the protection scope of the present application.

## Claims

1. A power supply device (10), **characterized by** comprising:
a housing assembly (11);
a battery (12), arranged in the housing assembly (11);
a circuit board assembly (13), arranged in the housing assembly (11) and in electrical connection with the battery (12);
a touch screen (141), mounted on the housing assembly (11) and in electrical connection with the circuit board assembly (13); and
an unlock switch (15), in electrical connection with the circuit board assembly (13) and configured to lock or unlock the touch screen (141).

2. The power supply device (10) according to claim 1, further comprising a start switch (142), wherein the start switch (142) is in electrical connection with the circuit board assembly (13), and the unlock switch (15) is further configured to lock or unlock the start switch (142).

3. The power supply device (10) according to claim 1, wherein the unlock switch (15) comprises:
a switch plate (151), in electrical connection with the circuit board assembly (13); and
an unlock portion (152), connected with the switch plate (151) and configured to slide on the switch plate (151) to lock or unlock the touch screen (141).

4. The power supply device (10) according to claim 3, further comprising a toggle member (16) and a limit member (17), wherein
the limit member (17) is connected with the housing assembly (11), and the toggle member (16) is slidably arranged on the housing assembly (11) and connected with the unlock portion (152) to drive the unlock portion (152) to move; and
the toggle member (16) is provided with a plurality of first concave portions (1601) spaced apart in a sliding direction of the unlock portion (152), the limit member (17) is provided with a first convex portion (1711), the first convex portion (1711) is configured to alternately engage with the plurality of first concave portions (1601) in a concave-convex fitting manner; and/or the limit member (17) is provided with a plurality of second concave portions spaced apart in the sliding direction of the unlock portion (152), the toggle member (16) is provided with a second convex portion, the second convex portion is configured to alternately engage with the plurality of second concave portions in a concave-convex fitting manner.

5. The power supply device (10) according to any one of claims 1-4, wherein
the power supply device (10) further comprises a gas pressure sensing element (18), which is arranged in the housing assembly (11) and in electrical connection with the circuit board assembly (13) and is configured to sense gas pressure changes; and
the housing assembly (11) is provided with a first gas vent (1101) in communication with the gas pressure sensing element (18).

6. The power supply device (10) according to claim 5, wherein
the circuit board assembly (13) comprises a circuit board (131) arranged in the housing assembly (11);
the battery (12), the touch screen (141), the unlock switch (15), and the gas pressure sensing element (18) are all in electrical connection with the circuit board (131);
the circuit board (131) is provided with a first through hole (1301), the gas pressure sensing element (18) is arranged on one side of the circuit board (131) and covers the first through hole (1301); and
the power supply device (10) further comprises a first seal (191), the first seal (191) is sealed at a side of the circuit board (131) away from the gas pressure sensing element (18), and an orthographic projection of the first seal (191) on the circuit board (131) covers the first through hole (1301); and a second through hole (1901) is formed through the first seal (191), and the second through hole (1901) communicates between the first through hole (1301) and the first gas vent (1101).

7. The power supply device (10) according to claim 6, wherein
a sealing groove (1102) is provided in the housing assembly (11), and the sealing groove (1102) comprises a mounting groove section (11021) and a liquid accumulation groove section (11022);
the mounting groove section (11021) is arranged at the side of the circuit board (131) away from the gas pressure sensing element (18), and at least a portion of the first seal (191) is installed in the mounting groove section (11021); and
the liquid accumulation groove section (11022) is in communication with an end of the mounting groove section (11021) away from the circuit board (131), and the first gas vent (1101) is in communication with the liquid accumulation groove section (11022).

8. The power supply device (10) according to claim 6, wherein
the housing assembly (11) is provided with a protective portion (1121) on a side of the battery (12), and the first gas vent (1101) is defined at the protective portion (1121);
the power supply device (10) further comprises a second seal (192), the second seal (192) is arranged at a side of the protective portion (1121) away from the battery (12), and a gas venting passage (101), which is in communication with the first gas vent (1101), is formed between the second seal (192) and the protective portion (1121); and
a plurality of second gas vents (1902) are formed through the second seal (192) and spaced apart from each other, the plurality of second gas vents (1902) communicate with each other via the gas venting passage (101), and the plurality of second gas vents (1902) are configured to alternately mate with and communicate with an atomization device (20).

9. The power supply device (10) according to claim 8, wherein
the housing assembly (11) is further provided with a mounting portion (1111), the mounting portion (1111) is enclosed around outer peripheries of the protective portion (1121) and the second seal (192), and is enclosed with the second seal (192) to form a mounting slot (102), which is configured to mount the atomization device (20);
the plurality of second gas vents (1902) are exposed in the mounting slot (102); and
on a projection surface perpendicular to a distribution direction of the second seal (192) and the protective portion (1121), an inner contour of the mounting slot (102) is a centrally symmetrical and non-circular, and the plurality of the second gas vents (1902) are symmetrically arranged relative to a center point of the mounting slot (102).

10. The power supply device according to claim 4, wherein
the limit member (17) comprises a limit portion (171) and a plurality of hooks (172), and the plurality of hooks (172) are spaced apart from each other and arranged on the limit portion (171).

11. The power supply device according to claim 10, wherein
a plurality of mounting holes (1104) are spaced apart from each other and are arranged at one end of the housing assembly (11) along a third direction (Y); the limit portion (171) is limited at one end of the housing assembly (11) along the third direction (Y); and the plurality of hooks (172) pass through the plurality of mounting holes (1104), respectively, and are elastically connected with the housing assembly (11).

12. The power supply device according to claim 4, wherein the toggle member (16) comprises a slide portion (161) and a toggle portion (162) connected with the slide portion (161), and the toggle portion (162) is connected with the unlock portion (152).

13. The power supply device according to claim 4, further comprising a light guide frame (113) and a transparent cover (114);
in a second direction (Z), at least a portion of the light guide frame (113) is arranged on a side of the circuit board assembly (13) away from the battery (12), and at least a portion of the transparent cover (114) is arranged on a side of the light guide frame (113) away from the light guide frame (113); and
the transparent cover (114) is provided with a window (1105), and the touch screen (141) is mounted at the window (1105).

14. The power supply device according to claim 4, further comprising a third seal (193), wherein
the third seal (193) is arranged at one end of the housing assembly (11) where the limit member (17) is located, and the toggle member (16) protrudes out of the third seal (193).

15. An electronic atomizer (100), **characterized by** comprising:
the power supply device (10) according to any one of claims 1-9; and
an atomization device (20), configured to connect the housing assembly (11) of the power supply device (10) and to establish an electrical connection with the circuit board assembly (13).
